(19) **Europäisches Patentamt**
**European Patent Office**
**Office européen des brevets**

(11) **EP 4 625 043 A2**

(12) **EUROPEAN PATENT APPLICATION**

(43) Date of publication:
**01.10.2025 Bulletin 2025/40**

(21) Application number: **25159703.5**

(22) Date of filing: **24.02.2025**

(51) International Patent Classification (IPC):
**G03F 7/004** $^{(2006.01)}$ **G03F 7/075** $^{(2006.01)}$
**G03F 7/16** $^{(2006.01)}$ **G03F 7/00** $^{(2006.01)}$

(52) Cooperative Patent Classification (CPC):
**G03F 7/161; C07F 7/2224; C23C 16/407;
C23C 16/45553; G03F 7/0042; G03F 7/0043;
G03F 7/0755; G03F 7/162; G03F 7/167;
G03F 7/2002; G03F 7/70033; H01L 21/0337**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.03.2024 US 202418620187**

(71) Applicant: **INTEL Corporation
Santa Clara, CA 95054 (US)**

(72) Inventors:
• **MOKHTARZADEH, Charles
Portland, 97217 (US)**

• **Karpe, SANJANA
Hillsboro, 97124 (US)**
• **CLENDENNING, Scott B.
Portland, 97225 (US)**
• **BLACKWELL JR, James
Portland, 97201 (US)**
• **DOYLE, Lauren
Portland, 97239 (US)**
• **HOLYBEE, Brandon
Portland, 97203 (US)**

(74) Representative: **HGF
HGF Limited
1 City Walk
Leeds LS11 9DX (GB)**

(54) **TIN CARBOXYLATE PRECURSORS FOR METAL OXIDE RESIST LAYERS AND RELATED METHODS**

(57) Tin carboxylate precursors for metal oxide resist layers and related methods are disclosed herein. An example method of fabricating a semiconductor device disclosed herein includes synthesizing a precursor including tin, depositing a metal oxide resist layer on a base material by applying the precursor, the metal oxide resist layer including tin-6 clusters, and patterning the metal oxide resist layer.

FIG. 2A

**Description**

FIELD OF THE DISCLOSURE

This disclosure relates generally to semiconductor device fabrication and, more particularly, to tin carboxylate precursors for metal oxide resist layers and related methods.

BACKGROUND

Semiconductor device fabrication includes various processes to manufacture integrated circuits or chips. Many processes involved in semiconductor device fabrication involve the use of photolithography. Photolithography involves the application of light onto a layer of light-sensitive material (e.g., photoresist, also sometimes referred to simply as a resist) in a controlled manner to produce a pattern in the layer of material in which portions of the layer of material are retained while other portions are removed. Often, the exposure of light onto a photoresist is controlled through the use of a photolithography mask (e.g., a photomask or simply mask, etc.).

BRIEF DESCRIPTION OF THE DRAWINGS

FIG. 1 illustrates an example system that includes a photomask to photolithographically pattern materials in an integrated circuit (IC) package and a metal oxide resist layer implemented in accordance with teachings of this disclosure.
FIG. 2A is a schematic diagram depicting the chemical composition of the metal oxide resist layer of FIG. 1 including a plurality of tin-6 clusters.
FIG. 2B is a chemical diagram of a first example tin-6 cluster morphology associated with the tin-6 clusters of FIG. 2A.
FIG. 2C is a chemical diagram of a second example tin-6 cluster morphology associated with the tin-6 clusters of FIG. 2A.
FIG. 3 is a diagram depicting an example chemical reaction between the precursors of FIG. 2A and the resulting deposition of the metal oxide resist layer of FIG. 2A.
FIG. 4A is a diagram depicting an example chemical reaction between the precursors of FIG. 2A to deposit the first tin-6 cluster morphology of FIG. 2B.
FIG. 4B a diagram depicting an example chemical reaction between the precursors of FIG. 2A to deposit the second tin-6 cluster morphology of FIG. 2C.
FIG. 5 is a chemical diagram depicting alternative reactants for synthesizing the tin carboxylate precursor of FIGS. 3 and 4.
FIGS. 6A-6D are example tables including example alkyl groups that can be used in conjunction with the precursors of FIG. 2A and the reactants of FIG. 5.
FIG. 7 is a block diagram for example operations for depositing and patterning the resist layer of FIGS. 1 and 2.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some, or all of these lines and/or boundaries may be idealized. In reality, the boundaries and/or lines may be unobservable, blended, and/or irregular.

DETAILED DESCRIPTION

In recent years, the use of low-wavelength ultraviolet light in lithography processes associated with semiconductor fabrication has been explored. Generally, lower wavelengths of ultraviolent light facilitate smaller features to be patterned on semiconductors, which enables the miniaturization thereof. Extreme ultraviolet lithography techniques utilize ultraviolet radiation with wavelengths of less than 13.5 nanometers. The use of ultraviolet light of such wavelengths requires the use of highly photo-sensitive materials due to the power demands of generating concentrated doses of such extreme ultraviolet light.

One such class of highly photo-sensitive materials is metal oxides, which can be used as metal oxide resist (MOR) layers in negative tone lithography processes. When exposed to UV light, MOR layers crosslink (e.g., agglomerate, etc.), which increases the strength of the crosslinked portions of the MOR layer. After exposure, the unexposed portion can be removed, and the underlying material can be patterned. Prior MOR materials exhibit low stability in atmospheric conditions, which can cause the MOR layer to degrade before patterning. The degradation of the resist layer can increase the required EUV light exposure intensity and/or duration, which increases the power requirements of the EUV source and/or the total flux of EUV light. Some current MOR materials are deposited with additives to increase the stability of the MOR material. However, the use of such additives can decrease the density of the MOR layer. This decreased density can decrease the photo-sensitivity of the MOR layer, which increases the EUV dose required to pattern the resist layer and the underlying base material.

Examples disclosed herein address one or more of the deficiencies described above and include metal oxide resist materials that include tin-6 clusters that are photo-sensitive, suitable for use in EUV lithography processes, and atmospherically stable. Example metal oxide resist layers described herein include tin-6 clusters, which are supported by carboxylic acid ligands. Example metal oxide resist layers described herein can be synthesized via a carboxylic acid precursors and water. The example carboxylic acid precursors described herein can include a variety of alkyl groups, which enable the selection of different carboxylic acids based on the application, desired reactivity, and the fabrication environment. For example, the carboxylic acids can be selected based on a desired density and photosensitivity of the metal oxide resist layer. Some example metal oxide resist layers described herein can be synthesized via an alkyl-tin-amide precursor, a carboxylic precursor, and water in chemical vapor deposition process. Example metal oxide resist materials described herein can be deposited via atomic layer deposition (ALD), chemical vapor deposition (CVD), and/or spin-on deposition.

Examples disclosed herein include references to chemical formulas and chemical equations. Generally, chemical formulas are referred to in their empirical forms (e.g., not their molecular form, etc.). Generally, elements in such chemical formulas and chemical equations are referred to herein by their chemical symbols (e.g., tin is referred to herein as "Sn," carbon is referred herein to as "C," hydrogen is referred to as "H," etc.). In the accompanying drawings, molecules are depicted via organic chemistry conventions (e.g., carbon atoms are unlabeled, etc.). Additionally, alkyl groups are referred to as "R" (e.g., a chemical formula including "R" could include any alkyl group, etc.). Methyl groups ($CH_3$) are referred to as "Me." Ethyl groups ($CH_2CH_3$) are referred to as "Et." Butyl groups ($C_4H_9$) are referred to as "Bu." Phenyl groups ($C_6H_5$) are referred to as "Ph." Trimethylsilyl groups ($C_3H_9Si$) are referred to as "TMS."

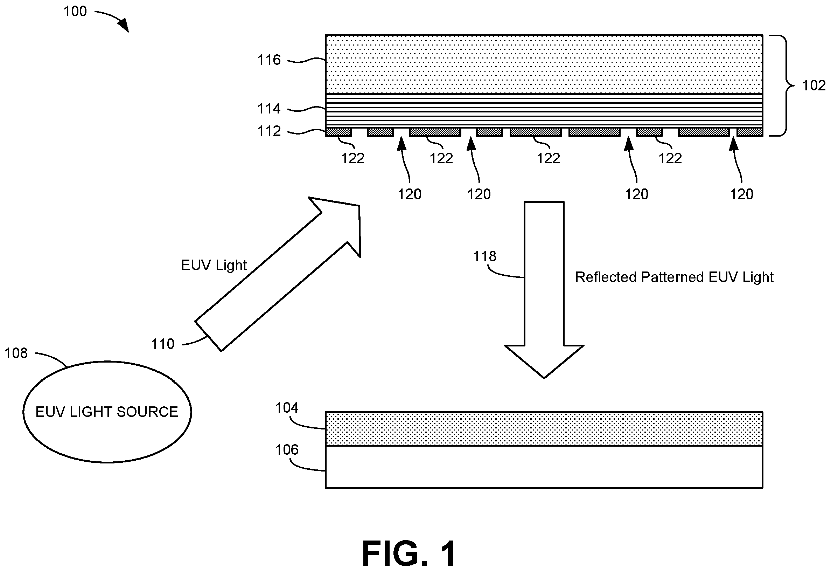

FIG. 1 illustrates an example system 100 that includes an example photomask 102 to photolithographically pattern a photoresist 104 on some underlying layer or substrate 106. In some examples, the underlying substrate 106 corresponds to a portion of an integrated circuit (IC) package. More particularly, in some instances, the underlying substrate 106 corresponds to a particular layer within a semiconductor die (e.g., an IC chip, etc.) within the IC package, a particular layer within a package substrate for the IC package, and/or any other suitable substrate. In some instances, the photoresist 104 is patterned to define openings in the photoresist 104 that can then be used as a mask to create corresponding openings in the underlying substrate 106 (e.g., through an etching process that removes portions of the underlying substrate exposed through the openings in the photoresist 104). In some instances, instead of removing portions of the underlying substrate 106 exposed through the openings in the photoresist 104, the openings in the photoresist 104 can be filled with a material to be added onto the underlying substrate 106 at the locations defined by the openings. In some instances, the photoresist 104 is removed after subsequent processing associated with the use of the patterned openings have been completed. In other instances, the photoresist 104 is retained on the underlying substrate 106 and remains as part of the final product (e.g., some portion of an IC package).

The system 100 of FIG. 1 is an extreme ultraviolet (EUV) lithography system. Accordingly, as shown in FIG. 1, the system 100 includes an EUV light source 108 that produces EUV light 110. More particularly, the EUV light source 108 can be a laser driven light source (e.g., based on tin plasma) that produces EUV light (e.g., ultraviolet light at a wavelength of approximately 13.5 nanometers (nm)). As shown in FIG. 1, the EUV light 110 is directed towards the photomask 102. The photomask 102 includes an absorber 112 (also referred to herein as an absorber layer) having a defined pattern on an outer surface of a multilayer 114 (also referred to herein as a multilayer region). The absorber 112 is an opaque material capable of absorbing the EUV light 110. The multilayer 114 is defined by a stack of thin films or layers of materials capable of reflecting the EUV light 110. As shown in FIG. 1, both the patterned absorber 112 and the multilayer 114 are carried by a support substrate 116. In some examples, the support substrate 116 is a solid piece of glass (e.g., a glass pane, panel, or sheet).

As the EUV light 110 reaches the photomask 102, the absorber 112 absorbs the EUV light 110. The reflective films within the multilayer 114 reflect at least a portion of the EUV light (referred to herein as reflected patterned EUV light 118) that is directed toward the photoresist 104. The reflected patterned EUV light 118 is defined by the pattern of the absorber 112. That is, as shown in FIG. 1, the pattern of the absorber 112 is defined by openings 120 between opaque regions 122 of the absorber 112. The opaque regions 122 absorb at least a portion of the EUV light 110 so that the absorbed portion of the EUV light 110 is not reflected toward the photoresist 104. The openings 120 expose portions of the underlying multilayer 114 and the exposed portions of the multilayer 114 will reflect at least a portion of the EUV light 110 (e.g., the reflected patterned EUV light 118) towards the photoresist 104.

In the illustrated example of FIG. 1, the photoresist 104 is a photo-sensitive metal oxide resist (MOR) layer. The portions of the photoresist 104 exposed to the reflected patterned EUV light 118 react to the light and change characteristics. In the illustrated example of FIG. 1, the system 100 is a negative tone lithography system. That is, portions of the photoresist 104 exposed to light will harden such that when a developer solution is applied to the photoresist 104, the portions that remain relatively soft (e.g., the portions not exposed to the light, etc.) are removed while the hardened portions remain (e.g. are not removed, etc.). In this manner, the pattern defined by the opaque regions 122 of the absorber 112 on the photomask 102 are transferred to the photoresist 104. In other examples, the portions of the photoresist 104 exposed to the patterned EUV light 118 are weakened (e.g., softened, etc.) such that, when a developer solution is applied the exposed portions of the photoresist 104 are removed. In this manner, the pattern defined by the openings 120 in the absorber 112 (e.g., the inverse of the pattern defined by the opaque regions 122) is transferred to the photoresist 104.

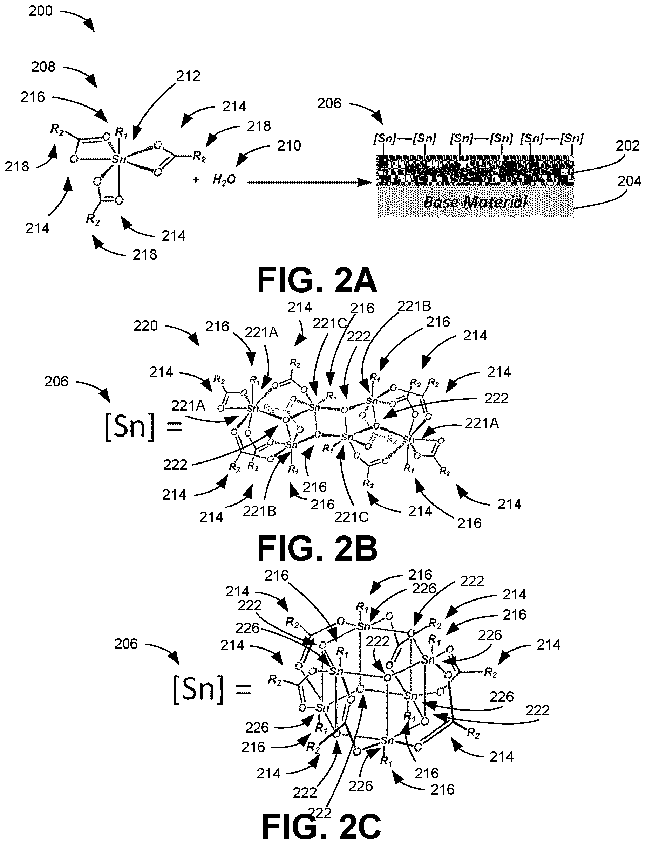

FIG. 2A is a schematic diagram of an example chemical reaction 200 that can be used to deposit an example metal oxide resist layer 202 implemented in accordance with teachings of this layer. In the illustrated example of FIG. 2B, the metal oxide resist layer 202 is deposited on an example base layer 204. In some examples, the metal oxide resist layer 202 and the base layer 204 can implement the photoresist 104 of FIG. 1 and the substrate 106 of FIG. 1, respectively. In the illustrated example of FIG. 2A, the metal oxide resist layer 202 includes an example plurality of tin-6 clusters 206. In the illustrated example of FIG. 2A, the chemical reaction 200 occurs between an example first precursor 208 and an example second precursor 210. In the illustrated example of FIG. 2A, the first precursor 208 includes an example tin atom 212, three example carboxylate ligands 214, and an example alkyl ligand 216.

The metal oxide resist layer 202 is composed of a plurality of the tin-6 clusters 206. In the illustrated example of FIG. 2A, the metal oxide resist layer 202 is a thin film of tin carboxylate. In some examples, the metal oxide resist layer 202 can be deposited via atomic layer deposition (ALD) (e.g., the chemical reaction 200 is associated with ALD, etc.). For example, the precursors 208, 210 can be alternatively pulsed into a reaction chamber including the base layer 204. In some such examples, the thickness of the metal oxide resist layer 202 can be controlled via the number of pulses of the precursors 208, 210 (e.g., each cycle of pulses of the precursors 208, 210 deposits a single molecule layer of the tin-6 clusters 206, etc.). In other examples, the metal oxide resist layer 202 can be deposited via chemical vapor deposition (CVD). For example, the precursors 208, 210 can be applied simultaneously to the base layer 204 as gases (e.g., as vapors, etc.). In some such examples, the thickness of the metal oxide resist layer 202 can be controlled via the length of the exposure to the precursors 208, 210 (e.g., a long exposure time causes a thicker metal oxide resist layer, etc.). In other examples, the metal oxide resist layer 202 can be applied via a spin-on technique. In some examples, the precursors 208, 210 can be mixed in a solution (e.g., water, an organic solvent, etc.), applied to the base layer 204, and spread thereon by spinning the base layer 204 at high speeds (e.g., spinning coating the first precursor 208, etc.). In some examples, the thickness of the metal oxide resist layer 202 can be controlled by the volume of the precursors 208, 210 applied to the base layer 204.

The base layer 204 is the material that is to be patterned via lithography. The base layer 204 is also referred to herein as the base material. In some examples, the base layer 204 includes (e.g., is composed of, etc.) silicon dioxide (e.g., silica, $SiO_2$, etc.).. In some examples, the base layer 204 is a component of an integrated circuit (e.g., a die, a package substrate, etc.) and/or another apparatus that includes extremely small components. Additionally or alternatively, the base layer 204 can include a metal (e.g., copper, aluminum, nickel, etc.). In some examples, after the removal of selected portions of the metal oxide resist layer 202 (e.g., via etching, etc.), the base layer 204 can be patterned to form openings and/or holes in the base layer 204. In some examples, the openings created in the base layer 204 can have a resolution of less than 20 nm (e.g., based on the wavelength of the applied UV light, etc.).

The tin-6 clusters 206 are the base unit of the metal oxide resist layer 202. The tin-6 clusters 206 are a photo-sensitive molecules. In the illustrated example of FIG. 2A, the tin-6 clusters 206 have not been exposed to ultraviolet light and each one of the tin-6 clusters 206 is coupled to two other ones of the tin-6 clusters 206. In some such examples, the coupling of the tin-6 clusters 206 prior to exposure can occur due to thermal crosslinking. In other examples, the tin-6 clusters can be less crosslinked than depicted in FIG. 2A prior to exposure to UV light. In some examples, when the tin-6 clusters 206 are exposed to ultraviolet light (e.g., EUV, etc.), adjacent ones of the tin-6 clusters 206 can further aggregate and/or crosslink. That is, the application of ultraviolet light ionizes the tin-6 clusters 206 and causes the activation of tin-alkyl bonds of the tin-6 clusters 206. The crosslinking of the tin-6 clusters 206 makes the exposed portions of the metal oxide resist layer 202 resistant to removal (e.g., via etching, etc.). As such, by selectively exposing portions of the metal oxide resist layer 202 to UV light (e.g., via the photomask 102 of FIG. 1, etc.), selective ones of the tin-6 clusters 206 can be crosslinked, unexposed ones of the tin-6 clusters 206 can be removed, and the metal oxide resist layer 202 can be patterned.

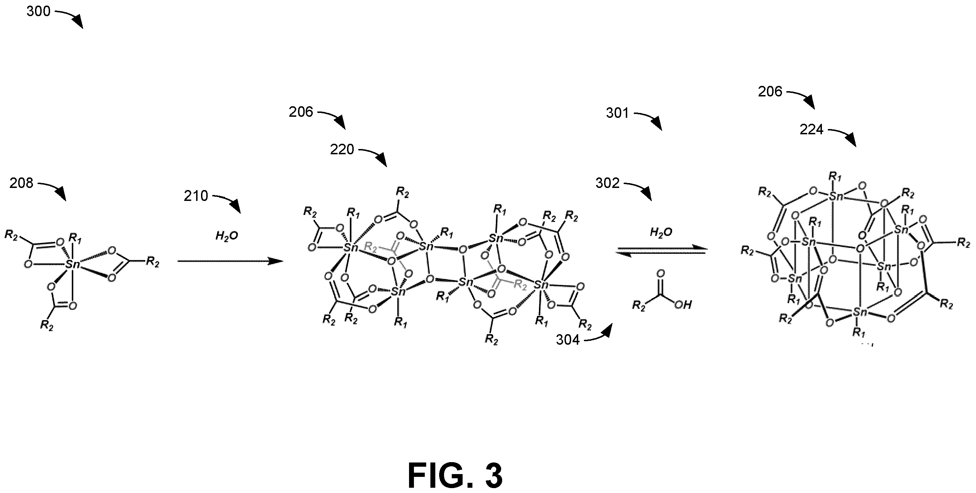

As used herein, the symbol [Sn] refers to the structure of the tin-6 cluster 206 of the metal oxide resist layer 202. Example tin-6 morphologies that can be included in the metal oxide resist layer 202 are depicted below in FIGS. 2A and 2B. It should be appreciated that the morphologies of FIGS. 2A and 2B can exist in an equilibrium in the metal oxide resist layer 202. In some examples, the conditions of the fabrication environment (e.g., the temperature, the pressure, the atmospheric composition of the environment, etc.) and/or the technique used to deposit the metal oxide resist layer 202. An example equilibrium between the tin-6 morphologies of FIGS. 2A and 2B is described below in conjunction with FIG. 3.

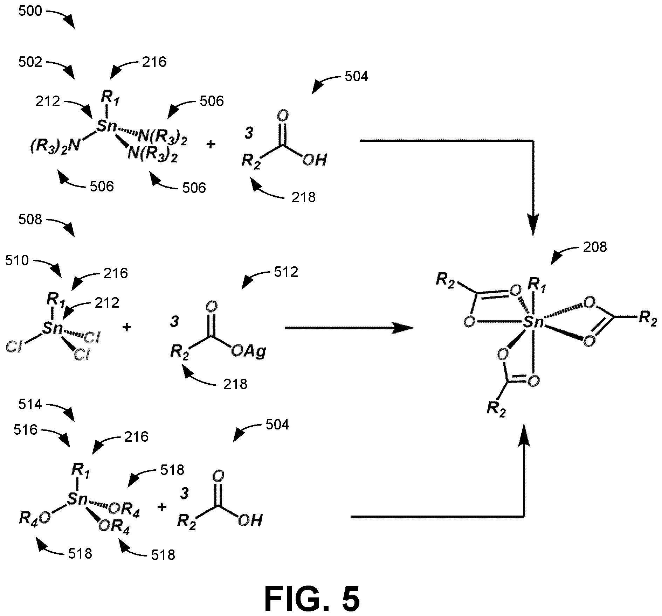

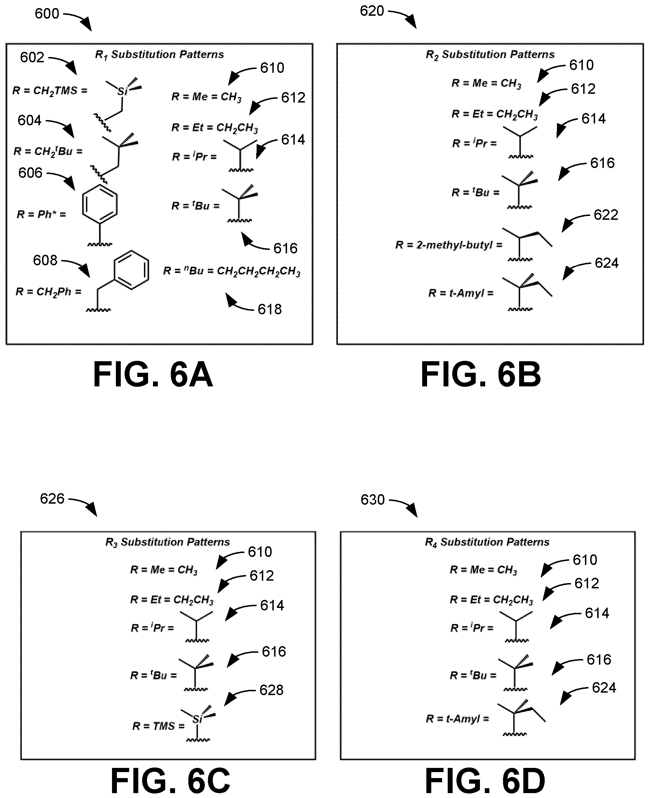

The first precursor 208 is an alkyl tin carboxylate. That is, the first precursor 208 includes the tin atom 212, which is bonded to the carboxylate ligands 214 and the first alkyl ligand 216. The carboxylate ligands 214 are conjugate bases of carboxylate acid. In the illustrated example of FIG. 2, each of the carboxylate ligands 214 includes an example second alkyl group 218. The carboxylate ligands 214 can be implemented by any suitable carboxylate group. That is, the second alkyl group 218 can be implemented by any suitable alkyl group (e.g., the carboxylate ligands 214 are acetic acid if the second alkyl group 218 is a methyl group, etc.). Example alkyls that can be used to implement the second alkyl group 218 are described below in conjunction with FIG. 6A. Example alkyls that can be used to implement first alkyl ligand 216 are described below in conjunction with FIG 6B. Example reactions that can be used to synthesize the first precursor 208 are described below in conjunction with FIG. 5. In the illustrated example of FIG. 2A, the second precursor 210 is water ($H_2O$). In other examples, the second precursor 210 can be any other suitable material. For example, the second precursor 210 can be bcarboxylic acid. In some such examples, the second precursor 210 can include a same alkyl group as the alkyl group of the first alkyl ligand 216 and/or the carboxylate ligands 214. In other examples, the second precursor 210 can include a different alkyl group.

FIG. 2B is a chemical diagram of a first tin-6 cluster morphology 220 that can implement the tin-6 cluster 206 of FIG. 2A. In the illustrated example of FIG. 2B, the first tin-6 cluster morphology 220 includes two first example tin atoms 221A, two example second tin atoms 221B, two example third tin atoms 221C, and two example central oxygen atoms 222. In the illustrated example of FIG. 2, the first tin-6 cluster morphology 220 includes six tin atoms (e.g., the tin atoms 221A, 221B, 221C etc.), which are donated by the first precursor 208 of FIG. 2A (e.g., the tin atoms 212 of FIG. 2, etc.). That is, the first tin-6 cluster morphology 220 has the following chemical formula:

$$Sn_6O_6(R_1)_6(OC(O)R_2)_8 \qquad\qquad (1)$$

where Sn is tin (e.g., the tin atoms 221A, 221B, 221C, etc.), O is the central oxygen atoms 222, C is carbon, $R_1$ is the first alkyl ligand 216, and $R_2$ is the second alkyl group 218. In the illustrated example of FIG. 2B, each of the first tin atoms 221A is bonded to one of the central oxygen atoms 222, one oxygen of three of the carboxylate ligands 214 of FIG. 2A, both oxygens of one of the carboxylate ligands 214 of FIG. 2A, and one of the first alkyl ligands 216. In the illustrated example of FIG. 2A, each of the second tin atoms 221B is bonded to two of the central oxygen atoms 222, one oxygen of three of the carboxylate ligands 214 of FIG. 2A, and one of the first alkyl ligands 216. In the illustrated example of FIG. 2A, each of the third tin atoms 221C is bonded to three of the central oxygen atoms 222, one oxygen of two of the carboxylate ligands 214 of FIG. 2A, and one of the first alkyl ligand 216. The first tin-6 cluster morphology 220 is referred to herein as the "ladder" morphology (e.g., the first tin-6 cluster morphology is ladder-shaped, etc.).

FIG. 2C is a chemical diagram of an example second tin-6 cluster morphology 224 that can implement the tin-6 cluster 206 of FIG. 2A. In the illustrated example of FIG. 2C, the second tin-6 cluster morphology 224 includes six example tin atoms 226 and six of the central oxygen atoms 222 of FIG. 2B. That is, the second tin-6 cluster morphology has the following chemical formula:

$$Sn_6O_6(R_1)_6(OC(O)R_2)_6 \qquad\qquad (2)$$

Where Sn is tin (e.g., the tin atoms 226, etc.), O is the central oxygen atoms 222, C is carbon, $R_1$ is the first alkyl ligand 216, and $R_2$ is the second alkyl group 218. In the illustrated example of FIG. 2C, the second tin-6 cluster morphology 224 includes six tin atoms (e.g., the tin atoms 226, etc.), which are donated by the first precursor 208 of FIG. 2A. Each of the tin atoms 226 is bonded to three of the central oxygen atoms 222, one oxygen of two of the carboxylate ligands 214 of FIG. 2A, and one of the first alkyl ligand 216. As used herein, the second tin-6 cluster morphology 224 is referred to herein as the "drum" morphology (e.g., the second tin cluster morphology is drum-shaped, etc.). That is, the second tin-6 cluster morphology 224 includes a hexagonal prism formed by the tin atoms 212 and the central oxygen atoms 222.

The alkyl ligands 216 of the morphologies of FIGS. 2A and 2B can crosslink with the tin atoms of adjacent ones of the tin-6 clusters 206. For example, the oxygen atoms of the carboxylate ligands 214 can be bonded to the tin atoms of adjacent ones of the tin-6 clusters 206 (e.g., one of the alkyl ligands 216 is bonded to two tin atoms 212, etc.). In some such examples, exposure to ultraviolet light during photolithography, a greater amount of the alkyl ligands 216 can be bonded to adjacent ones of the tin-6 clusters 206 (e.g., all of the alkyl ligands 216, etc.) to form chains of the tin-6 clusters 206. In some such examples, the greater number of crosslinks of the tin-6 clusters 206 increases the resistance of the tin-6 clusters 206 to etching, which enables the patterning of the layers 202, 204 via lithography.

FIG. 3 is a diagram depicting an example chemical reaction 300 between the precursors 208, 210 of FIG. 2A and the deposition of metal oxide resist layer 202 of FIG. 2A. In some examples, the chemical reaction 300 can occur via the simultaneous deposition of the precursors 208, 210 via chemical vapor deposition, via alternative pulses of the precursors 208, 210 via atomic layer deposition, and/or alternatively synthesized to be deposited on the base layer 204 via spin-on techniques. The chemical reaction 300 of FIG. 3 is set forth below in equation (3):

$$R_1 Sn(OC(O)R_2)_3 + H_2O \rightarrow Sn_6O_6(R_1)_6(OC(O)R_2)_8 \leftrightarrow$$
$$Sn_6O_6(R_1)_6(OC(O)R_2)_6 + OC(O)R_2 \qquad (3)$$

Where Sn is tin (e.g., the tin atoms 226, etc.), O is the central oxygen atoms 222, C is carbon, $R_1$ is the first alkyl ligand 216, $R_2$ is the second alkyl group 218, $R_1 Sn(OC(O)R_2)_3$ is the first precursor 208, $H_2O$ is the second precursor 210 (e.g., water, etc.), $Sn_6O_6(R_1)_6(OC(O)R_2)_8$ is a tin-6 cluster having the first tin-6 cluster morphology 220. In the illustrated example of FIG. 3, the first tin-6 cluster morphology 220 and the second tin-6 cluster morphology 224 exist in an example equilibrium 301 in the presence of example water 302. In the illustrated example of FIG. 3, the reaction 300 includes an example equilibrium 301 between the first tin-6 cluster morphology 220 and the second tin-6 cluster morphology 224. In some examples, the equilibrium 301 between the tin-6 cluster morphologies 220, 224 causes example carboxylic acids 304 to be exchanged between being dissolved in the water 302 and being incorporated into the first tin-6 cluster morphology 220. That is, each one of the tin-6 clusters 206 with the first tin-6 cluster morphology 220 includes two additional ones of the carboxylate ligands 214 when compared to the second tin-6 cluster morphology 224. In some examples, the equilibrium 301 is heavily weighted toward the second tin-6 cluster morphology 224. In some examples, the equilibrium 301 can be based on the temperature at which the chemical reaction 300 occurs (e.g., higher temperatures drive the equilibrium 301 toward the second tin-6 cluster morphology 224, etc.) and/or the volume of the second precursor 210 (e.g., higher concentrations of water drive the equilibrium 301 toward the second tin-6 cluster morphology 224, etc.).

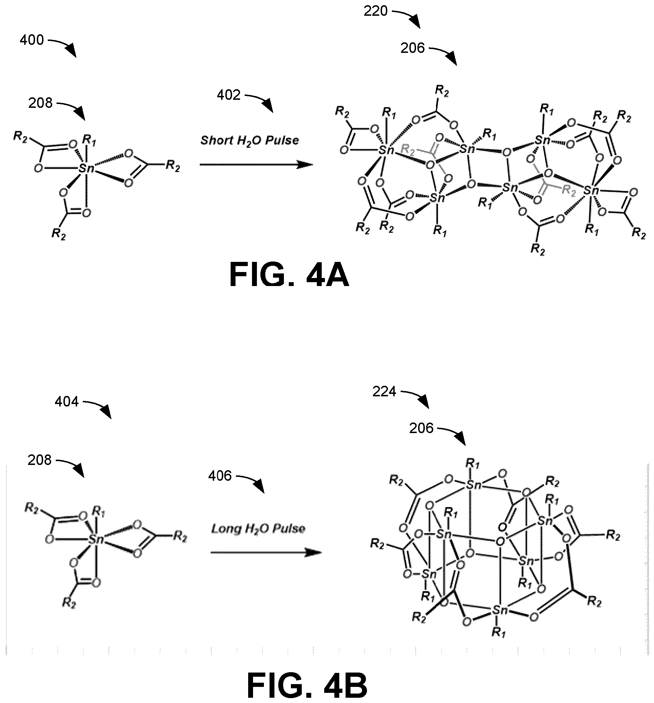

FIG. 4A is a diagram depicting an example chemical reaction 400 between the first precursor 208 and the second precursor 210 to deposit the first tin-6 cluster morphology 220 via atomic layer deposition and/or chemical vapor deposition. The chemical reaction 400 is similar to the chemical reaction 300. The chemical reaction 400 includes an example first water pulse 402 and can be associated with an ALD and/or CVD reaction. In the illustrated example of FIG. 4A, the application of the first water pulse 402 biases the chemical reaction 400 to cause the formation of a metal oxide resist layer (e.g., the metal oxide resist layer 202 of FIG. 2, etc.) that includes a majority of tin-6 clusters with the first tin-6 cluster morphology 220. In some examples, if the chemical reaction 400 is an atomic layer deposition process, the first water pulse 402 can be applied for less than two seconds (e.g., 250 milliseconds, 500 milliseconds, 1 second etc.). In some examples, if the chemical reaction 400 is a chemical vapor deposition process, the first water pulse 402 can be applied at a comparatively low pressure (e.g., 1 torr, etc.).

FIG. 4B is an example second chemical reaction 404 diagram between the first precursor 208 and the second precursor 210 to deposit the second tin-6 cluster morphology 224 via atomic layer deposition and/or chemical vapor deposition. The second chemical reaction 404 is similar to the chemical reaction 300. The second chemical reaction 404 includes an example second water pulse 406 and can be associated with an ALD and/or CVD reaction. In the illustrated example of FIG. 4B, the application of the second water pulse 406 biases the second chemical reaction 404 to cause the formation of a metal oxide resist layer (e.g., the metal oxide resist layer 202 of FIG. 2, etc.) that includes a majority of tin-6 clusters with the second tin-6 cluster morphology 224. In some examples, if the second chemical reaction 404 is an atomic layer deposition process, the second water pulse 406 can be applied for greater than thirty seconds (e.g., 1 minute, 2 minutes, etc.). In some examples, if the second chemical reaction 404 is a chemical vapor deposition process, the second water pulse 406 can be applied at a comparatively greater pressure (e.g., 2 torrs, 3 torrs, etc.).

FIG. 5 is a chemical diagram depicting a variety of reactions for the synthesis of the first precursor 208. In the illustrated example of FIG. 5, an example first reaction 500 for the synthesis of the first precursor 208 is between an example first reactant 502 and an example second reactant 504. In the illustrated example of FIG. 5, the first reactant 502 is an alkyl tin amide and includes the tin atom 212 of FIG. 2 bonded to the first alkyl ligand 216 of FIG. 2 and three example amide groups including third alkyl groups 506. Example alkyls that can be used to implement the third alkyl groups 506 are described below in conjunction with FIG. 6C. In the illustrated example of FIG. 5, the second reactant 504 is an example carboxylate acid, which includes the second alkyl group 218 of FIG. 2. The chemical reaction 500 is set forth below in equation (4):

$$R_1[\![Sn(N(R)\!]\!]_3)_2)_3 + 3R_2COOH \rightarrow R_1 Sn(OC(O)R_2)_3 + [\![N(R)\!]\!]_3)_2 H \qquad (4)$$

where $R_1[\![Sn(N(R)\!]\!]_3)_2)_3$ is the first reactant 502 (e.g., alkyl tin amide, etc.), $3R_2COOH$ is the second reactant 504, $R_1 Sn(OC(O)R_2)_3$ is the first precursor 208, and $[\![N(R)\!]\!]_3)_2 H$ is an amine. In the illustrated example of FIG. 5, $[\![N(R)\!]\!]_3)_2 H$ is a byproduct of the first reaction 500.

In the illustrated example of FIG. 5, an example second chemical reaction 508 for the synthesis of the first precursor 208 is between an example third reactant 510 and an example fourth reactant 512. In the illustrated example of FIG. 5, the first reactant 502 is an alkyl tin chloride (e.g., alkyl tin trichloride, etc.) and includes the tin atom 212 of FIG. 2A bonded to the first alkyl ligand 216 of FIG. 2A and three example chlorines. In the illustrated example of FIG. 5, the second reactant 504 is a silver carboxylate which includes the second alkyl group 218 of FIG. 2A. The first chemical reaction 500 is set forth below in equation (5):

$$R_1SnCl_3 + 3R_2COOAg \rightarrow R_1Sn(OC(O)R_2)_3 + 3AgCl \qquad (5)$$

where $R_1SnCl_3$ is the third reactant 510 (e.g., alkyl tin chloride, etc.), $3R_2COOAg$ is the fourth reactant 512, $R_1Sn(OC(O)R_2)_3$ is the first precursor 208, and $AgCl$ is silver chloride. Silver chloride is a byproduct of the second chemical reaction 508.

In the illustrated example of FIG. 5, an example third reaction 514 for the synthesis of the first precursor 208 is between an example fifth reactant 516 and the second reactant 504. In the illustrated example of FIG. 5, the first reactant 502 is an alkyl tin alkoxide and includes the tin atom 212 of FIG. 2 bonded to the first alkyl ligand 216 of FIG. 2 and three example alkoxy groups including fourth alkyl groups 518. Example alkyls that can be used to implement the fourth alkyl groups 518 are described below in conjunction with FIG. 6D. The third chemical reaction 514 is set forth below in equation (6):

$$R_1[Sn(OR]_4)_3 + 3R_2COOH \rightarrow R_1Sn(OC(O)R_2)_3 + HOR_4 \qquad (6)$$

where $R_1[Sn(OR]_4)_3$ is the fifth reactant 516 (e.g., alkyl tin alkoxide, etc.), $3R_2COOH$ is the second reactant 504, $R_1Sn(OC(O)R_2)_3$ is the first precursor 208, and $HOR_4$ is an alkoxide. In the illustrated example of FIG. 5, $HOR_4$ is a byproduct of the third reaction 514.

FIG. 6A is an example first table 600 of alkyl groups that can be used to implement the first alkyl ligand 216 of the first precursor 208 of FIGS. 2-5. In the illustrated example of FIG. 6A, the first table 600 includes an example first alkyl 602, an example second alkyl 604, an example third alkyl 606, an example fourth alkyl 608, an example fifth alkyl 610, an example sixth alkyl 612, an example seventh alkyl 614, an example eighth alkyl 616, and an example nineth alkyl 618. In the illustrated example of FIG. 6A, the first alkyl 602 is a trimethylsilyl methylene group. That is, the first alkyl 602 includes a silicon (Si) atom bond to three methyl groups and a methylene. In the illustrated example of FIG. 6A, the second alkyl 604 is a tert-butyl methylene group. That is, the second alkyl 604 is a t-butyl group bonded to a methylene group (e.g., a methylene bridge, etc.). In the illustrated example of FIG. 6A, the third alkyl 606 is a phenyl group (e.g., a phenyl ring, etc.). In the illustrated example of FIG. 6A, the fourth alkyl 608 is a phenyl methylene group. That is, the fourth alkyl 608 is a phenyl group bonded to a methylene group (e.g., a methylene bridge, etc.). In the illustrated example of FIG. 6A, the fifth alkyl 610 is a methyl group. In the illustrated example of FIG 6A, the sixth alkyl 612 is an ethyl group. In the illustrated example of FIG. 6A, the seventh alkyl group 614 is a propyl group. In the illustrated example of FIG. 6A, the eighth alkyl 616 is a tert-butyl group. In the illustrated example of FIG. 61A, the nineth alkyl 618 is a normal butyl group. The first alkyl ligand 216 of the first precursor 208 can be implemented by a trimethylsilyl methylene group (e.g., the first alkyl 602, etc.), a tert-butyl methylene group (e.g., the second alkyl 604, etc.), a phenyl group (e.g., the third alkyl 606, etc.), a phenyl methylene group (e.g., the fourth alkyl 608, etc.), a methyl group (e.g., the fifth alkyl 610, etc.), an ethyl group (e.g., the sixth alkyl 612, etc.), a propyl group (e.g., the seventh alkyl group 614, etc.), a tert-butyl group (e.g., the eighth alkyl 616, etc.), or a normal butyl group (e.g., the nineth alkyl 618, etc.). In other examples, the first alkyl ligand 216 can be implemented by another suitable alkyl.

FIG. 6B is an example second table 620 of alkyl groups that can be used to implement the second alkyl group 218 of the first precursor 208 of FIGS. 2-5. That is, the second table 620 includes alkyl groups that can be included in the carboxylate ligands 214 of FIG. 2. In the illustrated example of FIG. 6B, the second table 620 includes the example fifth alkyl 610 of FIG. 6A, the example sixth alkyl 612 of FIG. 6A, the example seventh alkyl 614 of FIG. 6A, the example eighth alkyl 616 of FIG. 6A, an example tenth alkyl 622, and an example eleventh alkyl 624. In the illustrated example of FIG. 6B, the tenth alkyl 622 of FIG. is a2-methyl-butyl group. That is, the tenth alkyl 622 is a butyl group bond to two methyl groups (e.g., two methyl bridges, etc.). In the illustrated example of FIG. 6B, the eleventh alkyl 624 is a tertiary-amyl group (e.g., a branched pentyl group, etc.). The second alkyl group 218 of the carboxylate ligands 214 of the first precursor 208 can be implemented by a methyl group (e.g., the fifth alkyl 610, etc.), an ethyl group (e.g., the sixth alkyl 612, etc.), a propyl group (e.g., the seventh alkyl group 614, etc.), a tert-butyl group (e.g., the eighth alkyl 616, etc.), a 2-methy-butyl group (e.g., the tenth alkyl 622, tec.), or a tertiary-amyl group (e.g., the eleventh alkyl 624, etc.). In other examples, the second alkyl group 218 can be implemented by another suitable alkyl.

FIG. 6C is an example third table 626 of alkyl groups that can be used to implement the third alkyl group 506 of the first reactant 502 of FIGS. 5. That is, the third table 626 includes alkyl groups that can be included amide of the first reactant 502 of FIG. 5. In the illustrated example of FIG. 6C, the third table 626 includes the example fifth alkyl 610 of FIGS. 6A and 6B, the example sixth alkyl 612 of FIGS. 6A and 6B, the example seventh alkyl 614 of FIGS. 6A and 6B, the example eighth alkyl 616 of FIGS. 6A and 6B, an example twelfth alkyl 628. In the illustrated example of FIG. 12, the twelfth alkyl 628 is a TMS group. The third alkyl group 506 of the amide of the first reactant 502 can be implemented by a methyl group (e.g., the fifth alkyl 610, etc.), an ethyl group (e.g., the sixth alkyl 612, etc.), a propyl group (e.g., the seventh alkyl group 614, etc.), a tert-butyl group (e.g., the eighth alkyl 616, etc.), or a TMS group (e.g., the twelfth alkyl 628, etc.). In other examples, the third alkyl group 506 can be implemented by another suitable alkyl.

FIG. 6D is an example fourth table 630 of alkyl groups that can be used to implement the fourth alkyl group 518 of the fifth reactant 516 of FIG. 5. That is, the fourth table 630 includes alkyl groups that can be included in alkoxide of the fifth reactant 516 of FIG. 5. In the illustrated example of FIG. 6D, the fourth table 630 includes the example fifth alkyl 610 of FIGS. 6A-6C, the example sixth alkyl 612 of FIGS. 6A-6C, the example seventh alkyl 614 of FIGS. 6A-6C, the example eighth alkyl 616 of FIGS. 6A-6C, and the example eleventh alkyl 624 of FIG. 6B. The fourth alkyl group 518 of the alkoxide of the fifth reactant 516 of FIG. 5 can be implemented by a methyl group (e.g., the fifth alkyl 610, etc.), an ethyl group (e.g., the sixth alkyl 612, etc.), a propyl group (e.g., the seventh alkyl group 614, etc.), a tert-butyl group (e.g., the eighth alkyl 616, etc.), or a tertiary-amyl group (e.g., the eleventh alkyl 624, etc.). In other examples, the fourth alkyl group 518 can be implemented by another suitable alkyl.

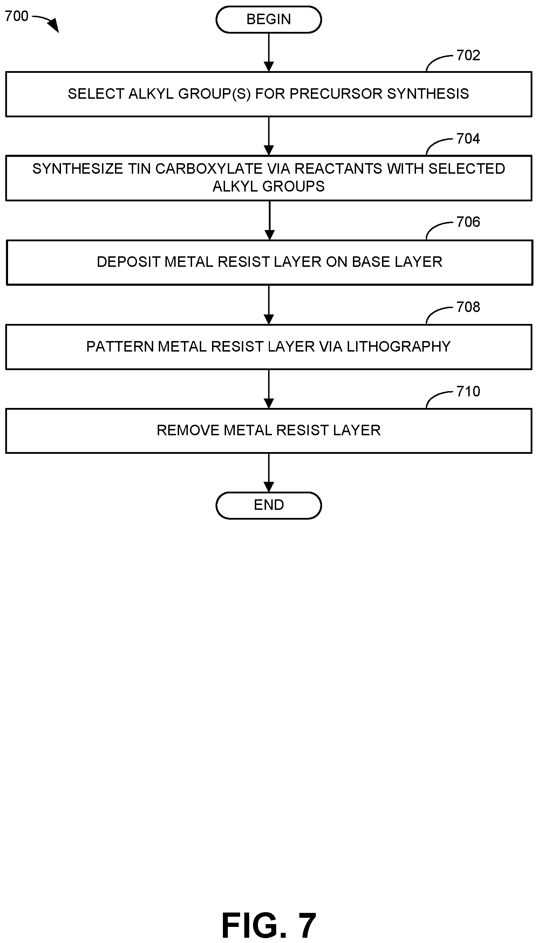

FIG. 7 is a block diagram for depositing and patterning the metal oxide resist layer 202 of FIGS. 1 and 2 including the tin-6 clusters of FIGS. 2A and/or 2B. The operations 700 begin at block 702, at which the alkyl group(s) for the synthesis of the first precursor 208 are selected. For example, the first alkyl ligand 216 can be selected from among a group consisting of the alkyls 602-618 of the first table 600 of FIG. 6A. In some examples, the second alkyl group 218 can be selected from a group consisting of the alkyls 610, 612. 614, 616, 622, 624 of the second table 620 of FIG. 6B. If the first reaction 500 of FIG. 5 is to be used to synthesize the first precursor 208, the third alkyl group 506 can be selected from among a group consisting of the alkyls 610, 612. 614, 616, 622, 628 of the third table 626 of FIG. 6C. If the third reaction 514 of FIG. 5 is to be used to synthesize the first precursor 208, the fourth alkyl group 518 can be selected from among a group consisting of the alkyls 610, 612. 614, 616, 624 of the fourth table 630 of FIG. 6D. In some examples, the alkyl group(s) for the synthesis of the first precursor 208 can be selected based on the desired density and photosensitivity of the deposited metal oxide resist layer.

At block 704, the first precursor 208 is synthesized via one or more of the chemical reactions 500, 508, 514 of FIG. 5. In other examples, the first precursor 208 can be synthesized by any other suitable process. In other examples, the synthesis of the first precursor 208 can be omitted. In some such examples, the reactants 502, 504 of the first reaction 500 can be deposited on the base layer 204 during the deposition of the metal oxide resist layer 202 associated with block 706.

At block 706, the metal oxide resist layer 202 is deposited on the base layer 204. For example, the first precursor 208 and the second precursor 210 (e.g., water, etc.) can be applied simultaneously as vapors (e.g., gases, etc.) directly on the base layer 204 via chemical vapor deposition. In other examples, the first reactant 502 of FIG. 5, the second reactant 504 of FIG. 5, and the second precursor 210 can be applied simultaneously as vapors on the base layer 204 via chemical vapor deposition. That is, an alkyl-tin-amide (e.g., the first reactant 502, etc.), a carboxylate acid (e.g., the second reactant 504, etc.), and water can be applied to the base layer 204 via chemical vapor deposition. Additionally or alternatively, the first precursor 208 and the second precursor 210 can be applied alternatively via vapor pulses via atomic layer deposition. In other examples, the first precursor 208 can be dissolved in a solution (e.g., water, etc.) and spun onto the base layer 204. In some such examples, the solution can be evaporated, which leaves the metal oxide resist layer 202 on the base layer 204.

At block 708, the metal oxide resist layer 202 is patterned. For example, the metal oxide resist layer 202 can be exposed to ultraviolet light with a wavelength of less than 20 nanometers (e.g., 13.5 nanometers, etc.), which causes the crosslinking (e.g., polymerization, etc.) of the exposed portions of the metal oxide resist layer 202. In some examples, openings in the metal oxide resist layer 202 are created by etching (e.g., dry etching, wet etching, etc.) the metal oxide resist layer 202, which removes the non-crosslinked portions of the metal oxide resist layer 202. In some examples, the base layer 204 can be patterned via semiconductor manufacturing techniques (e.g., ALD, CVD, electroplating, laser sintering, etc.). At block 710, the metal oxide resist layer 202 is removed. For example, the metal oxide resist layer 202 can be mechanically moved (e.g., planarization, etching, etc.). The operations 700 end.

Although the example operations 700 are described with reference to the flowchart illustrated in FIG. 7, many other methods of assembling an interconnect implemented in accordance with the teachings of this disclosure may alternatively be used. For example, the order of execution of the blocks may be changed, and/or some of the blocks described may be changed, eliminated, or combined.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor component (e.g., a transistor), a semiconductor die containing a semiconductor component, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor component) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor components are often used in orientation different than their orientation during fabrication. Thus, when referring to a semiconductor component (e.g., a transistor), a semiconductor die containing a semiconductor component, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

Tin carboxylate precursors for metal oxide resist layers and related methods are disclosed herein. Further examples and combinations thereof include the following:

Example 1 includes a method of fabricating a semiconductor device, the method comprising synthesizing a precursor including tin, depositing a metal oxide resist layer on a base material by applying the precursor, the metal oxide resist layer including tin-6 clusters, and patterning the metal oxide resist layer.

Example 2 includes the method of any preceding example, wherein the precursor includes a carboxylate ligand.

Example 3 includes the method of any preceding example, wherein the precursor includes an alkyl ligand.

Example 4 includes the method of any preceding example, wherein the depositing the metal oxide resist layer includes applying of the precursor and water via chemical vapor deposition.

Example 5 includes the method of any preceding example, wherein the depositing the metal oxide resist layer includes applying of alternative pulses of the precursor and water via atomic layer deposition.

Example 6 includes the method of any preceding example, wherein the patterning of the metal oxide resist layer includes applying ultraviolet light having a wavelength of less than 20 nanometers.

Example 7 includes the method of any preceding example, wherein the depositing of the metal oxide resist layer to the base material includes spinning coating a solution including the precursor on the base material.

Example 8 includes the method of any preceding example, wherein the precursor is a first precursor, and further including applying a second precursor including carboxylic acid.

Example 9 includes the method of any preceding example, wherein the precursor includes an alkyl-tin-amide.

Example 10 includes the method of any preceding example, wherein the depositing of the metal oxide resist layer includes applying the precursor, a carboxylic acid, and water via chemical vapor deposition.

Example 11 includes the method of any preceding example, wherein the precursor includes an alkyl tin carboxylate.

Example 12 includes the method of any preceding example, wherein the depositing the metal oxide resist layer includes spin coating the precursor on the base material, and applying water to the base material.

Example 13 includes the method of any preceding example, wherein the synthesizing of the precursor includes reacting a first reactant and a second reactant, the first reactant including the tin, chlorine, and an alkyl group, the second reactant including a silver carboxylate.

Example 14 includes the method of any preceding example, wherein the synthesizing of the precursor includes reacting a first reactant and a second reactant, the first reactant including the tin, an amide group, and an alkyl group, and the second reactant including a carboxylic acid.

Example 15 includes the method of any preceding example, wherein the synthesizing of the precursor includes reacting a first reactant and a second reactant, the first reactant including the tin, an alkoxy group, and an alkyl group, and the second reactant including a carboxylic acid.

Example 16 includes the method of any preceding example, wherein the precursor includes at least one of (1) a trimethylsilyl methylene group, (2) a tert-butyl methylene group, (3) a phenyl group, (4) a phenyl methylene group, (5) a methyl group, (6) an ethyl group, (7) a propyl group, (8) a tert-butyl group, or (9) a normal butyl group.

Example 17 includes a semiconductor device comprising a semiconductor base layer, and a metal oxide resist layer on the base layer, the metal oxide resist layer including a plurality of tin atoms and a carboxylate ligand.

Example 18 includes the semiconductor device of any preceding example, wherein the tin atoms are arranged in a drum-shape.

Example 19 includes the semiconductor device of any preceding example, wherein the carboxylate ligand includes at least one of (1) a trimethylsilyl methylene group, (2) a tert-butyl methylene group, (3) a phenyl group, (4) a phenyl methylene group, (5) a methyl group, (6) an ethyl group, (7) a propyl group, (8) a tert-butyl group, or (9) a normal butyl group.

Example 20 includes the semiconductor device of any preceding example, wherein the metal oxide resist layer includes openings having a resolution of less than 20 nanometers.

For the foregoing, it will be appreciated that semiconductor fabrication methods and devices made thereby have been disclosed herein. In some examples, the metal oxide resist layers include tin-6 clusters disclosed herein have increased stability when compared to prior metal oxide resist layers. The tin-6 clusters disclosed herein are very photo-sensitive and suitable for use EUV photo lithography. Examples disclosed herein enable deposition of such stable photo-sensitive metal oxide resist layer via a variety of deposition techniques, including atomic layer deposition, chemical vapor deposition, and spin-on deposition.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

**Claims**

1. A method of fabricating a semiconductor device, the method comprising:

   synthesizing a precursor including tin;
   depositing a metal oxide resist layer on a base material by applying the precursor, the metal oxide resist layer including tin-6 clusters; and
   patterning the metal oxide resist layer.

2. The method of claim 1, wherein the precursor includes a carboxylate ligand and an alkyl ligand.

3. The method of claim 2, wherein the depositing the metal oxide resist layer includes applying of the precursor and water via chemical vapor deposition.

4. The method of claim 2, wherein the depositing the metal oxide resist layer includes applying of alternative pulses of the precursor and water via atomic layer deposition.

5. The method of claim 1, wherein the depositing of the metal oxide resist layer to the base material includes spinning coating a solution including the precursor on the base material.

6. The method of claim 1, wherein the precursor includes an alkyl tin carboxylate.

7. The method of any preceding claim, wherein the synthesizing of the precursor includes reacting a first reactant and a second reactant, the first reactant including the tin, chlorine, and an alkyl group, the second reactant including a silver carboxylate.

8. The method of any one of claims 1-6, wherein the synthesizing of the precursor includes reacting a first reactant and a second reactant, the first reactant including the tin, an amide group, and an alkyl group, and the second reactant including a carboxylic acid.

9. The method of any one of claims 1-6, wherein the synthesizing of the precursor includes reacting a first reactant and a second reactant, the first reactant including the tin, an alkoxy group, and an alkyl group, and the second reactant including a carboxylic acid.

10. The method of claim 1, wherein the precursor includes an alkyl-tin-amide and the depositing of the metal oxide resist layer includes applying the precursor, a carboxylic acid, and water via chemical vapor deposition.

11. The method of any preceding claim, wherein the patterning of the metal oxide resist layer includes applying ultraviolet light having a wavelength of less than 20 nanometers.

12. A semiconductor device comprising:

a semiconductor base layer; and
a metal oxide resist layer on the semiconductor base layer, the metal oxide resist layer including a plurality of tin atoms and a carboxylate ligand.

13. The semiconductor device of claim 12, wherein the tin atoms are arranged in a drum-shape.

14. The semiconductor device of any one of claims 12 or 13, wherein the carboxylate ligand includes at least one of (1) a trimethylsilyl methylene group, (2) a tert-butyl methylene group, (3) a phenyl group, (4) a phenyl methylene group, (5) a methyl group, (6) an ethyl group, (7) a propyl group, (8) a tert-butyl group, or (9) a normal butyl group.

15. The semiconductor device of any one of claims 12-14, wherein the metal oxide resist layer includes openings having a resolution of less than 20 nanometers.

FIG. 1

EP 4 625 043 A2

FIG. 2A

FIG. 2B

FIG. 2C

FIG. 3

FIG. 4A

FIG. 4B

**FIG. 5**

FIG. 6A

FIG. 6B

FIG. 6C

FIG. 6D

700 ⟶

BEGIN

┌─────────────────────────────────────────────┐
│  SELECT ALKYL GROUP(S) FOR PRECURSOR SYNTHESIS │  ⟋ 702
└─────────────────────────────────────────────┘

┌─────────────────────────────────────────────┐
│  SYNTHESIZE TIN CARBOXYLATE VIA REACTANTS WITH SELECTED │  ⟋ 704
│  ALKYL GROUPS                                 │
└─────────────────────────────────────────────┘

┌─────────────────────────────────────────────┐
│  DEPOSIT METAL RESIST LAYER ON BASE LAYER      │  ⟋ 706
└─────────────────────────────────────────────┘

┌─────────────────────────────────────────────┐
│  PATTERN METAL RESIST LAYER VIA LITHOGRAPHY    │  ⟋ 708
└─────────────────────────────────────────────┘

┌─────────────────────────────────────────────┐
│  REMOVE METAL RESIST LAYER                     │  ⟋ 710
└─────────────────────────────────────────────┘

END

# FIG. 7